# EUROPÄISCHE PATENTSCHRIFT

(11) **EP 1 273 078 B1**
(45) Veröffentlichungstag und Bekanntmachung des Hinweises auf die Patenterteilung: **01.06.2005**
(21) Anmeldenummer: 01969064.3
(22) Anmeldetag: 20.03.2001
(51) Int. Cl.: H01S 5/024, H01S 5/068

(54) **DIODENLASEREINRICHTUNG MIT KÜHLUNG UND FUNKTIONSÜBERWACHUNG**
DIODE LASER DEVICE WITH COOLING SYSTEM AND SYSTEMS FUNCTIONS MONITORING SYSTEM
DISPOSITIF A DIODES LASER A REFROIDISSEMENT ET MOYENS DE REGULATION DU FONCTIONNEMENT

(30) Priorität: 13.04.2000 DE 10018421
(43) Veröffentlichungstag der Anmeldung: 08.01.2003
(73) Patentinhaber: TRUMPF Laser GmbH + Co. KG, 78713 Schramberg (DE)
(72) Erfinder: HUBER, Rudolf, 78647 Trossingen (DE); HUONKER, Martin, 78337 Öhningen (DE); NOTHEIS, Thomas, Konrad, 78713 Schramberg (DE); WALLMEROTH, Klaus, 78658 Zimmern (DE)
(74) Vertreter: Beck, Jürgen,
(86) Internationale Anmeldenummer: PCT/EP2001/003165
(87) Internationale Veröffentlichungsnummer: WO 2001/080383

(56) Entgegenhaltungen:
- EP-A- 0 425 309
- DE-A- 4 010 054
- US-A- 5 495 490
- US-A- 5 579 328

## Beschreibung

Die Erfindung betrifft eine Diodenlasereinrichtung, umfassend mindestens eine Laserdiode, eine Stromversorgung für die Laserdiode und eine Kühleinrichtung mit einem Kühlkörper, auf welchem die Laserdiode angeordnet ist, sowie mit einer Kühlmittelversorgung, welche ein Kühlmedium durch den Kühlkörper strömen läßt.

Derartige Diodenlasereinrichtungen sind aus dem Stand der Technik bekannt, wie z.B. aus US-A-5 495 490. Bei diesen besteht das Problem, daß eine einwandfreie Funktion derselben nur dadurch überprüfbar ist, daß die abgegebene Laserstrahlung entweder durch kalorimetrische oder optische Leistungsmeßgeräte gemessen wird, wobei die optische Leistungsmessung je nach Ausführungsform problematisch sein kann.

Dies macht es erforderlich, in dem Strahlungsweg der Laserstrahlung einen entsprechenden Meßkopf anzuordnen, so daß die Diodenlasereinrichtung während der Messung nicht bestimmungsgemäß, beispielsweise zum Pumpen eines Festkörperlasers, genutzt werden kann.

Der Erfindung liegt daher die Aufgabe zugrunde, eine Diodenlasereinrichtung der gattungsgemäßen Art derart zu verbessern, daß eine Funktionsüberwachung in einfacher Weise und ohne Beeinträchtigung der Nutzung der Diodenlasereinrichtung möglich ist.

Diese Aufgabe wird bei einer Diodenlasereinrichtung der eingangs beschriebenen Art erfindungsgemäß dadurch gelöst, daß eine Funktionsüberwachungseinrichtung vorgesehen ist und daß die Funktionsüberwachungseinrichtung eine den durch die Laserdiode fließenden elektrischen Strom repräsentierende Größe und eine die Temperatur des aus dem Kühlkörper austretenden Kühlmediums repräsentierende Größe erfaßt und hieraus eine die Funktion der Diodenlasereinheit repräsentierende Funktionsgröße bestimmt.

Der Vorteil der erfindungsgemäßen Lösung ist darin zu sehen, daß die Bestimmung der Funktionsgröße ohne Eingriff in den Strahlengang der Laserstrahlung erfolgen kann und somit auch während der bestimmungsgemäßen Nutzung der Diodenlasereinrichtung beispielsweise zum Pumpen eines Festkörperlasers.

Ferner hat die erfindungsgemäße Lösung den großen Vorteil, daß die Bestimmung der Funktionsgröße mit einfachen Mitteln erfolgen kann, da lediglich die den durch die Laserdiode fließenden Strom repräsentierende Größe und die die Temperatur des aus dem Kühlkörper austretenden Kühlmediums repräsentierende Größe bestimmt werden müssen, die sich mit einfachen Mitteln erfassen lassen.

Für die Erfassung der die Temperatur des aus dem Kühlkörper austretenden Kühlmediums repräsentierenden Größe sind eine Vielzahl von indirekten oder direkten Methoden denkbar. Wird beispielsweise das aus dem Kühlkörper austretende Kühlmedium auf eine bestimmte Temperatur abgekühlt, so wäre es denkbar, die zur Abkühlung erforderliche Kühlleistung zu erfassen.

Aus Gründen der Einfachheit ist es jedoch besonders vorteilhaft, wenn die Funktionsüberwachungseinrichtung die Temperatur des aus dem Kühlkörper austretenden Kühlmediums mittels eines Sensors erfaßt.

Zur noch genaueren Bestimmung der Funktionsgröße hat es sich als vorteilhaft erwiesen, wenn die Funktionsüberwachungseinrichtung eine die Temperaturdifferenz zwischen dem in den Kühlkörper eintretenden und dem aus dem Kühlkörper austretenden Kühlmedium repräsentierende Größe ermittelt.

Eine derartige Ermittlung der die Temperaturdifferenz repräsentierenden Größe kann beispielsweise indirekt durch Ermittlung der Kühlleistung zum Erreichen einer festgelegten Temperatur für das in den Kühlkörper eintretende Kühlmedium erfolgen.

Besonders einfach ist es jedoch, wenn die Funktionsüberwachungseinrichtung die Temperatur des in den Kühlkörper eintretenden Kühlmediums mittels eines Sensors erfaßt.

Prinzipiell ist die Funktionsgröße aufgrund der Temperaturmessungen mit ausreichender Genauigkeit bestimmbar, allerdings ist die Genauigkeit noch dann steigerbar, wenn die Funktionsüberwachungseinrichtung den Durchfluß des Kühlmediums durch den Kühlkörper erfaßt.

Besonders vorteilhaft läßt sich dies direkt dadurch erreichen, daß die Funktionsüberwachungseinrichtung den Durchfluß des Kühlmediums durch den Kühlkörper mit einem Durchflußmesser erfaßt.

Eine besonders günstige Lösung, welche eine hohe Genauigkeit bei der Bestimmung der Funktionsgröße erlaubt, sieht vor, daß die Funktionsüberwachungseinrichtung eine die durch die Kühleinrichtung von der Laserdiode abgeführte Wärmeleistung repräsentierende thermische Größe bestimmt, mit weicher sich zumindest näherungsweise die von der Laserdiode nicht in Form von Strahlung abgegebene Wärmeleistung erfassen läßt.

Prinzipiell wäre es bei der Bestimmung der den elektrischen Strom durch die Laserdiode repräsentierenden Größe denkbar, Einstellparameter der Stromversorgung zu erfassen, wobei hieraus zumindest indirekt auf den elektrischen Strom durch die Laserdiode geschlossen werden kann.

Besonders günstig ist es jedoch aus Gründen einer möglichst genauen Bestimmung der Funktionsgröße, insbesondere einer möglichst genauen Bestimmung der Änderungen der Funktionsgröße, wenn die Funktionsüberwachungseinrichtung eine Strommeßeinrichtung umfaßt, welche den durch die Laserdiode fließenden elektrischen Strom erfaßt.

Bei einer Laserdiode kann davon ausgegangen werden, daß die an dieser abfallende Spannung ungefähr konstant ist. Um jedoch die Funktionsgröße mit möglichst hoher Genauigkeit zu bestimmen, ist vorzugsweise vorgesehen, daß die Funktionsüberwachungseinrichtung eine Spannungsmeßeinrichtung umfaßt, welche die an der Laserdiode im Betrieb abfallende Spannung erfaßt.

Eine besonders hohe Präzision bei der Bestimmung der Funktionsgröße ist dann erreichbar, wenn die Funktionsüberwachungseinrichtung eine die der Laserdiode zugeführte elektrische Leistung repräsentierende elektrische Größe bestimmt, welche die gesamte, der Laserdiode zugeführte elektrische Leistung darstellt.

Eine besonders hohe Genauigkeit bei der Bestimmung der Funktionsgröße läßt sich dann erreichen, wenn die Funktionsüberwachungseinrichtung aus der elektrischen Größe und der thermischen Größe die Funktionsgröße bestimmt.

In die Bestimmung der Funktionsgröße können neben der elektrischen Größe und der thermischen Größe noch weitere Parameter eingehen.

Vorzugsweise werden die in die Bestimmung der FunktionsgröBe eingehenden Parameter so gewählt, daß die Funktionsgröße die optische Ausgangsleistung der Laserdiode repräsentiert, so daß die Funktionsgröße ein unmittelbares Maß für die optische Ausgangsleistung der Laserdiode darstellt und somit direkt die für die Funktion der Laserdiode wichtigste Angabe liefert.

Hinsichtlich der Ausbildung der Diodenlasereinrichtung wurde bislang lediglich davon ausgegangen, daß diese eine Laserdiode umfaßt. Besonders günstig läßt sich die erfindungsgemäße Lösung jedoch dann einsetzen, wenn die Diodenlasereinrichtung mehrere Laserdioden aufweist.

In diesem Fall ist vorzugsweise vorgesehen, daß die mehreren Laserdioden von einer gemeinsamen Stromversorgung gespeist sind.

Dabei läßt sich vorteilhafterweise die Funktionsgröße auch dann mit ausreichender Präzision bestimmen, wenn die den elektrischen Strom durch die Gesamtheit der Laserdioden repräsentierende Größe bestimmt wird.

Vorzugsweise geht somit in die elektrische Größe eine den elektrischen Strom durch die Gesamtheit der Laserdioden repräsentierende Größe und eine die an der Gesamtheit der Laserdioden abfallende Spannung repräsentierende Größe ein, wobei hierzu die Laserdioden elektrisch in Reihe geschaltet sind.

Auch bei der Bestimmung der die Temperatur des aus dem Kühlkörper austretenden Kühlmediums repräsentierenden Größe wird bei mehreren in der Diodenlasereinrichtung vorgesehenen Laserdioden auf die Temperatur des aus der Gesamtheit der Kühlkörper austretenden Kühlmediums abgestellt.

Vorzugsweise sind dabei die Kühlkörper der mehreren Laserdioden parallel von Kühlmedium durchströmt, so daß jede der Laserdioden im wesentlichen dieselbe Kühlleistung erfährt.

Hinsichtlich der Ausbildung der Kühleinrichtung wurden bislang keine näheren Angaben gemacht. Beispielsweise wäre es denkbar, das aus dem Kühlkörper oder den Kühlkörpern austretende Kühlmedium frei abzuleiten. Besonders vorteilhaft ist es jedoch, wenn die Kühleinrichtung einen Kühlkreislauf umfaßt, aus welchem über einen Wärmetauscher die Wärme abgeführt wird.

Hinsichtlich der Betriebsweise der erfindungsgemäßen Funktionsüberwachungseinrichtung wurden bislang keine näheren Angaben gemacht. So wäre es beispielsweise denkbar, die Funktionsüberwachungseinrichtung kontinuierlich zu betreiben und somit kontinuierlich die Funktionsgröße zu bestimmen.

Es ist aber auch ausreichend, die Funktionsgröße nach festgelegten Zeitintervallen oder nach festgelegten Betriebszyklen zu bestimmen, da in der Regel davon ausgegangen werden kann, daß sich die Funktionsgröße lediglich langsam und nicht unbedingt sprunghaft ändert.

Weitere Merkmale und Vorteile der erfindungsgemäßen Lösung sind Gegenstand der nachfolgenden Beschreibung sowie der zeichnerischen Darstellung eines Ausführungsbeispiels. In der Zeichnung zeigen:
- Fig. 1: eine schematische Darstellung einer erfindungsgemäßen Laserdiodeneinrichtung;
- Fig. 2: eine vergrößerte Darstellung zweier übereinanderliegender Lasereinheiten;
- Fig. 3: einen Schnitt längs Linie 3-3 in Fig. 2; und
- Fig. 4: ein Blockdiagramm zur schematischen Darstellung einer Arbeitsweise einer erfindungsgemäßen Funktionsüberwachungseinrichtung.

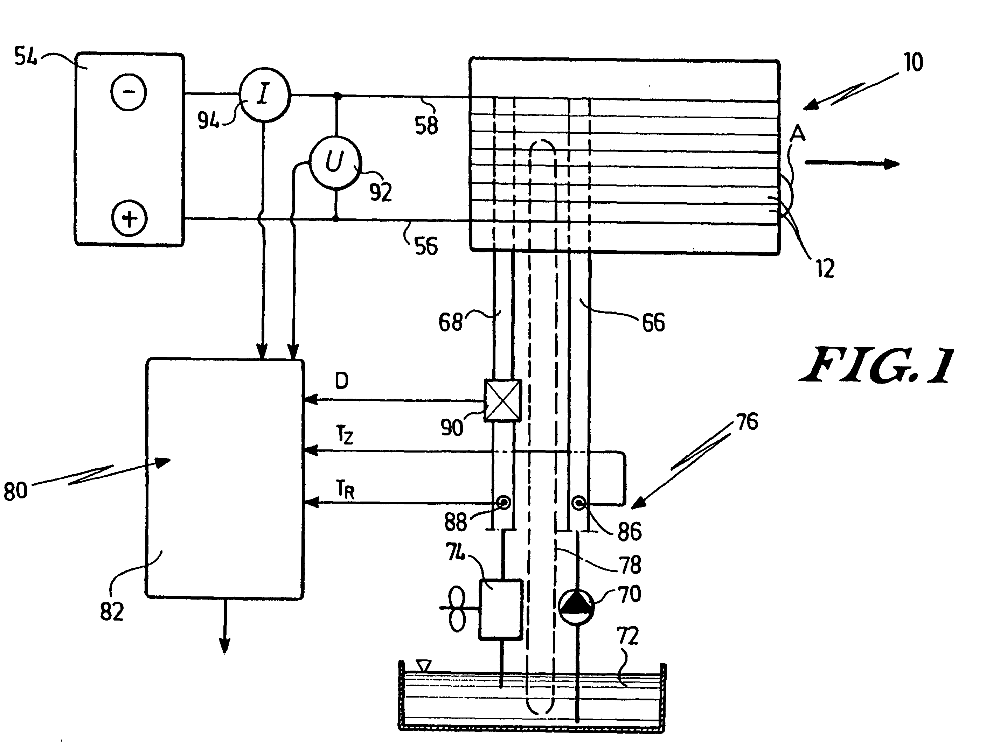

Ein Ausführungsbeispiel einer in Fig. 1 dargestellten Diodenlasereinheit umfaßt eine als Ganzes mit 10 bezeichnete Laserdiodenanordnung, welche durch einen Stapel von einzelnen Lasereinheiten 12 gebildet ist.

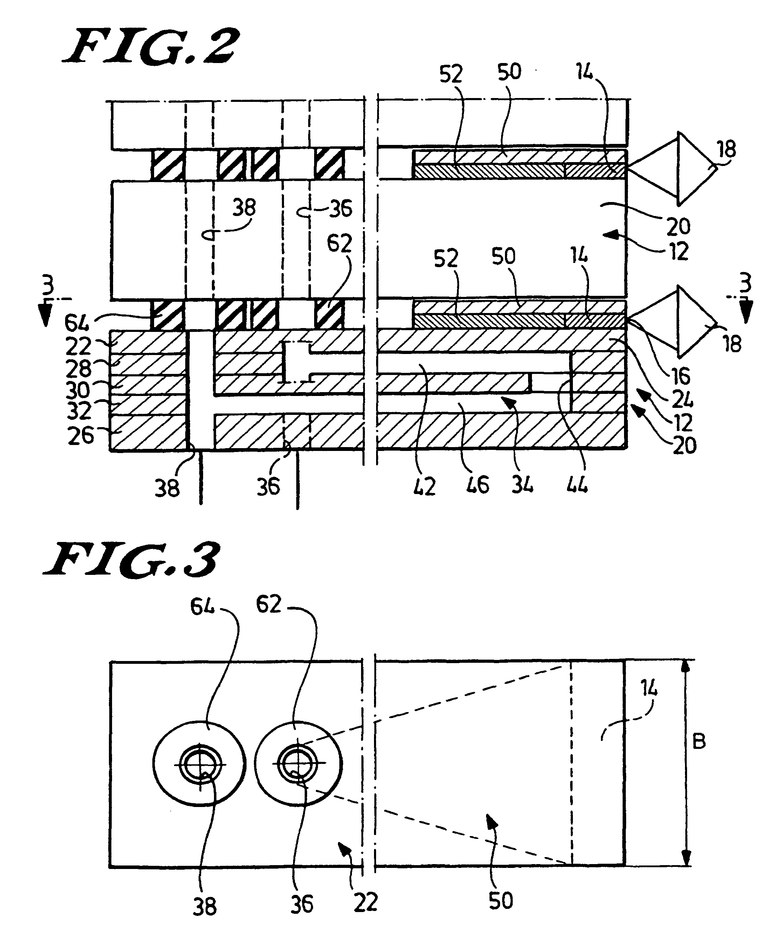

Jede der einzelnen Lasereinheiten 12 umfaßt, wie in Fig. 2 dargestellt, einen eine Laserdiode darstellenden Laserbarren 14, aus welchem an einer Frontseite 16 Laserstrahlung 18 austritt.

Der Laserbarren 14 liegt dabei auf einem als Ganzes mit 20 bezeichneten Kühlkörper, weicher eine Deckelplatte 22 umfaßt, auf welcher der Laserbarren 14 in einem vorderen Bereich 24 derselben mit Wärmekontakt aufliegt, und eine Grundplatte 26 sowie zwischen der Deckelplatte 22 und der Grundplatte 26 liegende Zwischenplatten 28, 30 und 32, welche zur Ausbildung eines Kühlkanatsystems 34 in dem Kühlkörper 20 dienen, das sich zwischen einem Zulaufkanal 36 und einem Rücklaufkanal 38 erstreckt, welche sowohl die Deckelplatte 22, die Zwischenplatten 28 bis 32 und die Grundplatte 26 im wesentlichen senkrecht zu deren Flächenausdehnung durchsetzen.

Beispielsweise bildet die Zwischenplatte 28 ausgehend von dem Zulaufkanal 36 einen ersten Kühlkanalabschnitt 42 des Kühlkanalsystems 34, welcher vom Zulaufkanal 36 unter der Deckelplatte 22 in Richtung des vorderen Bereichs 24 verläuft und nahe des vorderen Bereichs 24 der Deckelplatte 22 über einen Durchbruch 44 in einen zweiten Kühlkanalabschnitt 46 des Kühlkanalsystems 34 übergeht, welcher vom Durchbruch 44 auf einer der Deckelplatte 22 abgewandten Seite des Kühlkanalabschnitts 42 bis zum Rücklaufkanal 38 führt.

Damit ist durch das über den Zulaufkanal 36 in das Kühlkanalsystem 34 eintretende Kühlmedium unmittelbar die Deckelplatte 22 kühlbar, und zwar bis in ihren vorderen Bereich 24, auf weichem der Laserbarren 14 aufliegt und in weichen eine Abfuhr von Wärme aus dem Laserbarren 14 erfolgt.

Der gesamte Kühlkörper 20 dient ferner noch als erste Anschlußelektrode für den Laserbarren 14. Als zweite Anschlußelektrode 50 ist auf einer dem Kühlkörper 20 gegenüberliegenden Seite des Laserbarrens 14 ein Kontaktblech 50 aufgelegt, welches sich einerseits über den Laserbarren 14, und zwar dessen gesamte Breite B, erstreckt und sich ausgehend vom Laserbarren 14 noch über einen Teilbereich der Deckplatte 22 und dabei ebenfalls von der Deckelplatte 22 abgestützt ist, wobei zwischen dem Kontaktblech 50 und dem Kühlkörper 20 ein Isolator 52 vorgesehen ist.

Damit ist der Laserbarren 14 einerseits durch den Kühlkörper 20, andererseits durch das Kontaktblech 50 elektrisch kontaktiert.

Auf dem Kontaktblech 50 liegt nun in unmittelbarem elektrischen Kontakt mit diesem die nächste Lasereinheit 12 mit deren Kühlkörper 20 auf, so daß sämtliche Laserbarren 14 der Laserdiodenanordnung 10 elektrisch gesehen in Reihe geschaltet sind und beispielsweise von einer Stromversorgung 54 eine erste Stromzuleitung 56 zu dem Kühlkörper 20 der untersten Lasereinheit 12 der Laserdiodenanordnung 10 führt, während eine zweite Stromzuleitung 58 von der Stromversorgung 54 zu dem Kontaktblech 50 der obersten Lasereinheit 12 der Laserdiodenanordnung 10 führt.

Ferner sind der Zulaufkanal 36 und der Rücklaufkanal 38, die jeden der Kühlkörper 20 durchsetzen, in allen Lasereinheiten 12 fluchtend zueinander angeordnet, so daß die Zulaufkanäle 36 und die Rücklaufkanäle 38 der Gesamtheit der Kühlkörper 20 der Laserdiodenanordnung 10 durch zwischen den einzelnen Kühlkörpern 20 vorgesehene Ringdichtungen 62 und 64 miteinander verbindbar sind, die jeweils die Austrittsöffnungen des Zulaufkanals 36 und des Rücklaufkanals 38 bei einem Kühlkörper und die Eintrittsöffnungen des Zulaufkanals 36 und des Rücklaufkanals 38 beim anderen Kühlkörper umschließen und somit eine Verbindung zwischen den Zulaufkanälen 36 aller Kühlkörper 20 der Laserdiodenanordnung 10 und allen Rücklaufkanälen 38 aller Kühlkörper 20 der Laserdiodenanordnung 10 herstellen.

Folglich werden die Kühlkanalsysteme 34 aller Kühlkörper 20 parallel mit Kühlmedium versorgt und somit alle Laserbarren 14 der Laserdiodenanordnung 10 in gleicher Weise gekühlt.

Zur Kühlmittelversorgung der Laserdiodenanordnung 10 sind eine Zulaufleitung 66 und eine Rücklaufleitung 68 vorgesehen, welche zu der Laserdiodenanordnung 10 führen und beispielsweise mit dem Zulaufkanal 38 und dem Rücklaufkanal 38 des Kühlkörpers 20 der untersten Lasereinheit 12 verbunden sind.

Dabei wird in die Zulaufleitung 66 mittels einer Pumpe 70 Kühlmedium aus einem Reservoir 72 eingespeist, während das über die Rücklaufleitung 68 abgeführte aufgeheizte Kühlmedium einem Kühler 74 zugeführt wird, welcher das gekühlte Kühlmedium dann in das Reservoir 72 abgibt, aus welchem die Pumpe 70 wieder Kühlmedium ansaugt.

Somit bilden insgesamt das Reservoir 72, die Pumpe 70, die Zulaufleitung 66, die Gesamtheit der Zulaufkanäle 36 der Laserdiodenanordnung 10, die Gesamtheit der Kühlkanalsysteme 34 in den Kühlkörpern 20 der Laserdiodenanordnung 10, die Gesamtheit der Rücklaufkanäle 38 der Laserdiodenanordnung 10, die Rücklaufleitung 68 und der Kühler 74, der wiederum zum Reservoir 72 führt, eine als Ganzes mit 76 bezeichnete Kühleinrichtung mit einem Kühlkreislauf 78.

Die erfindungsgemäße Diodenlasereinrichtung ist ferner noch mit einer als Ganzes mit 80 bezeichneten Funktionsüberwachungseinheit versehen, welche eine Auswerteschaltung 82 umfaßt, die mit einem Temperatursensor 86 in der Zulaufleitung 66 und einem Temperatursensor 88 in der Rücklaufleitung 68 verbunden ist und ferner noch mit einem Durchflußmesser 90, der entweder in der Zulaufleitung 66 oder in der Rücklaufleitung 68 vorgesehen ist und die Menge des den Kühlkreislauf 78 durchströmenden Kühlmediums pro Zeiteinheit erfaßt.

Somit kann die Auswerteschaltung 82 mittels des Temperatursensors 86 die Zulauf temperatur T_{z}, mittels des Temperatursensors 88 die Rücklauftemperatur T_{R} und mittels des Durchflußmessers 90 den Durchfluß D von Kühlmittel pro Zeiteinheit durch den Kühlkreislauf 78 erfassen.

Ferner ist die Auswerteschaltung 82 noch mit einer Spannungserfassungseinheit 92 verbunden, welche die an der Gesamtheit der in Reihe geschalteten Laserbarren 14 anliegende elektrische Spannung U erfaßt und mit einer Stromerfassungseinheit 94, welche den von der Stromversorgung 54 durch die Gesamtheit der Laserbarren 14 der Laserdiodenanordnung 10 fließenden Strom I erfaßt.

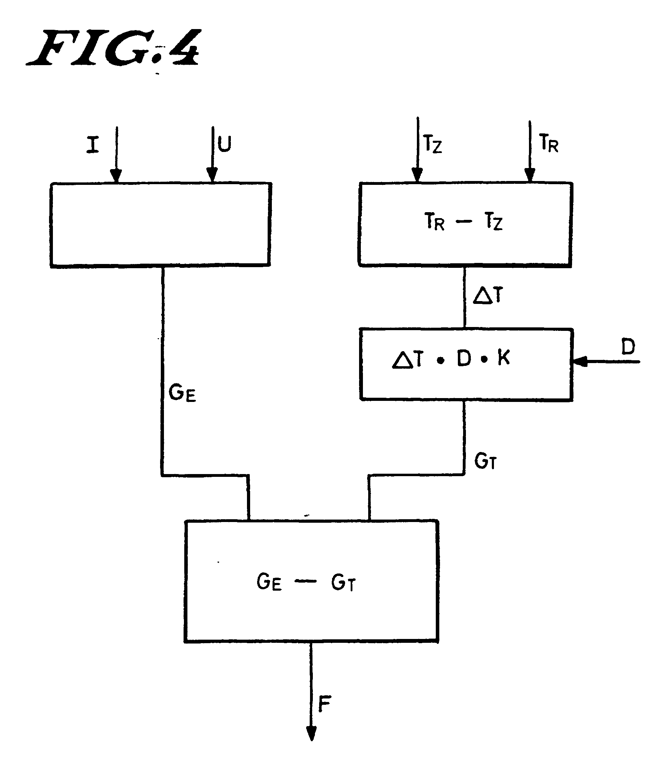

Wie in Fig. 4 dargestellt, arbeitet nun die Auswerteschaltung 82, beispielsweise mittels eines Prozessors so, daß zunächst aus der Zulauf temperatur T_{z} und der Rücklauftemperatur T_{R} durch Differenzbildung die Temperaturdifferenz ΔT ermittelt wird. Dann erfolgt durch Multiplikation der Temperaturdifferenz ΔT mit dem Durchfluß D und einem weiteren Parameter K die Ermittlung einer thermischen Größe G_{T}, welche die durch die Kühleinrichtung 76 abgeführte Wärmeleistung repräsentiert. Der Parameter K ist im einfachsten Fall eine Konstante, kann aber auch ein von der Temperaturdifferenz ΔT und/oder dem Durchfluß D abhängiges Parameterfeld sein.

Femer ermittelt die Auswerteschaltung 82, wie in Fig. 4 dargestellt, aus der Spannung U an der Gesamtheit der Laserbarren 14 und dem elektrischen Strom I durch die Gesamtheit der Laserbarren 14 durch Multiplikation eine elektrische Größe G_{E}, welche die der Laserdiodenanordnung 10 zugeführte elektrische Leistung repräsentiert.

Schließlich wird durch Differenzbildung zwischen der elektrischen Größe G_{E} und der thermischen Größe G_{T} eine Funktionsgröße F ermittelt, welche die von allen Laserbarren 14 abgegebene optische Leistung repräsentiert.

Die Funktionsgröße F erlaubt nun, einerseits die Funktion der Gesamtheit der Laserbarren 14 in der Laserdiodenanordnung 10 während der bestimmungsgemäßen Nutzung derselben, beispielsweise zum Pumpen eines Festkörperlasers, zu überwachen und somit festzustellen, ob beispielsweise durch Alterungserscheinungen der Laserbarren 14 die abgegebene optische Leistung abnimmt, was sich durch eine Verringerung der Funktionsgröße F äußert.

## Patentansprüche

1. Diodenlasereinrichtung umfassend mindestens eine Laserdiode (14), eine Stromversorgung (54) für die Laserdiode (14) und eine Kühleinrichtung (76), mit einem Kühlkörper (20), auf welchem die Laserdiode (14) angeordnet ist, sowie mit einer Kühlmittelversorgung (66, 68, 70, 72, 74), welche ein Kühlmedium durch den Kühlkörper (20) strömen läßt,
**dadurch gekennzeichnet, daß** eine Funktionsüberwachungseinrichtung (80) vorgesehen ist und daß die Funktionsüberwachungseinrichtung (80) eine den durch die Laserdiode (14) fließenden elektrischen Strom repräsentierende Größe (I) und eine die Temperatur des aus dem Kühlkörper (20) austretenden Kühlmediums repräsentierende Größe (T_{R}) erfaßt und hieraus eine die Funktion der Diodenlasereinrichtung repräsentierende Funktionsgröße (F) bestimmt.

2. Diodenlasereinrichtung nach Anspruch 1, **dadurch gekennzeichnet, daß** die Funktionsüberwachungseinrichtung (80) die Temperatur (T_{R}) des aus dem Kühlkörper (20) austretenden Kühlmediums mittels eines Sensors (88) erfaßt.

3. Diodenlasereinrichtung nach Anspruch 1 oder 2, **dadurch gekennzeichnet, daß** die Funktionsüberwachungseinrichtung (80) eine die Temperaturdifferenz (ΔT) zwischen dem in den Kühlkörper (20) eintretenden und dem aus dem Kühlkörper (20) austretenden Kühlmedium repräsentierende Größe (ΔT) ermittelt.

4. Diodenlasereinrichtung nach Anspruch 3, **dadurch gekennzeichnet, daß** die Funktionsüberwachungseinrichtung (80) die Temperatur (T_{Z}) des in den Kühlkörper (20) eintretenden Kühlmediums mittels eines Sensors (86) erfaßt.

5. Diodenlasereinrichtung nach einem der voranstehenden Ansprüche,
**dadurch gekennzeichnet, daß** die Funktionsüberwachungseinrichtung (80) eine den Durchfluß des Kühlmediums durch den Kühlkörper (20) repräsentierende Größe (D) erfaßt.

6. Diodenlasereinrichtung nach Anspruch 5, **dadurch gekennzeichnet, daß** die Funktionsüberwachungseinrichtung (80) die den Durchfluß des Kühlmediums durch den Kühlkörper (20) repräsentierende Größe (D) mit einem Durchflußmesser (90) erfaßt.

7. Diodenlasereinrichtung nach einem der voranstehenden Ansprüche,
**dadurch gekennzeichnet, daß** die Funktionsüberwachungseinrichtung (80) eine die durch die Kühleinrichtung (76) von der Laserdiode (14) abgeführte Wärmeleistung repräsentierende thermische Größe (G_{T}) bestimmt.

8. Diodenlasereinrichtung nach einem der voranstehenden Ansprüche,
**dadurch gekennzeichnet, daß** die Funktionsüberwachungseinrichtung (80) eine Strommeßeinrichtung (94) umfaßt, welche den in die Laserdiode (20) fließenden elektrischen Strom erfaßt.

9. Diodenlasereinrichtung nach einem der voranstehenden Ansprüche, **dadurch gekennzeichnet, daß** die Funktionsüberwachungseinrichtung eine die an der Laserdiode (14) abfallende elektrische Spannung repräsentierende Größe (U) erfaßt.

10. Diodenlasereinrichtung nach Anspruch 9, **dadurch gekennzeichnet, daß** die Funktionsüberwachungseinrichtung (80) eine Spannungsmeßeinrichtung (92) umfaßt, welche die an der Laserdiode (14) abfallende elektrische Spannung (U) erfaßt.

11. Diodenlasereinrichtung nach einem der voranstehenden Ansprüche, **dadurch gekennzeichnet, daß** die Funktionsüberwachungseinrichtung (80) eine die der Laserdiode (14) zugeführte elektrische Leistung repräsentierende elektrische Größe (G_{E}) bestimmt.

12. Diodenlasereinrichtung nach Anspruch 11, **dadurch gekennzeichnet**, daB die Funktionsüberwachungseinrichtung (80) aus der elektrischen Größe (G_{E}) und der thermischen Größe (G_{T}) die Funktionsgröße (F) bestimmt.

13. Diodenlasereinrichtung nach einem der voranstehenden Ansprüche, **dadurch gekennzeichnet, daß** die Funktionsgröße (F) die optische Ausgangsleistung der Laserdiode (14) repräsentiert.

14. Diodenlasereinrichtung nach einem der voranstehenden Ansprüche, **dadurch gekennzeichnet, daß** die Diodenlasereinrichtung mehrere Laserdioden (14) aufweist.

15. Diodenlasereinrichtung nach Anspruch 14, **dadurch gekennzeichnet, daß** die mehreren Laserdioden (14) elektrisch in Reihe geschaltet sind und daß die Funktionsüberwachungseinrichtung (80) den durch alle Laserdioden (14) fließenden elektrischen Strom erfaßt.

16. Diodenlasereinrichtung nach Anspruch 14 oder 15, **dadurch gekennzeichnet, daß** die Funktionsüberwachungseinrichtung (80) die an allen elektrisch in Reihe geschalteten Laserdioden (14) abfallende elektrische Spannung (U) erfaßt.

17. Diodenlasereinrichtung nach einem der Ansprüche 14 bis 16, **dadurch gekennzeichnet, daß** die Kühlkörper (20) der mehreren Laserdioden (14) vom Kühlmedium parallel durchströmt sind.

18. Diodenlasereinrichtung nach einem der voranstehenden Ansprüche, **dadurch gekennzeichnet, daß** die Kühleinrichtung (76) einen Kühlkreislauf (78) für das Kühlmedium aufweist.

## Claims

1. Diode laser device comprising at least one laser diode (14), a power supply (54) for the laser diode (14), and a cooling device (76), with a heat sink (20) on which the laser diode (14) is disposed, and with a coolant supply (66, 68, 70, 72, 74) which allows a coolant to flow through the heat sink (20), **characterized in that** an operation monitoring device (80) is provided, and **in that** the operation monitoring device (80) detects a quantity (I) representing the electric current flowing through the laser diode (14) and a quantity (T_{R}) representing the temperature of the coolant exiting from the heat sink (20) and determines from these an operational quantity (F) representing operation of the diode laser device.

2. Diode laser device in accordance with Claim 1, **characterized in that** the operation monitoring device (80) detects the temperature (T_{R}) of the coolant exiting from the heat sink (20) by means of a sensor (88).

3. Diode laser device in accordance with Claim 1 or 2, **characterized in that** the operation monitoring device (80) determines a quantity (ΔT) representing the temperature difference (ΔT) between the coolant entering the heat sink (20) and the coolant exiting from the heat sink (20).

4. Diode laser device in accordance with Claim 3, **characterized in that** the operation monitoring device (80) detects the temperature (T_{z}) of the coolant entering the heat sink (20) by means of a sensor (86).

5. Diode laser device in accordance with any one of the preceding claims, **characterized in that** the operation monitoring device (80) determines a quantity (D) representing the flow rate of the coolant through the heat sink (20).

6. Diode laser device in accordance with Claim 5, **characterized in that** the operation monitoring device (80) determines the quantity (D) representing the flow rate of the coolant through the heat sink (20) with a flowmeter (90).

7. Diode laser device in accordance with any one of the preceding claims, **characterized in that** the operation monitoring device (80) determines a thermal quantity (G_{T}) representing the thermal output conducted away from the laser diode (14) by the cooling device (76).

8. Diode laser device in accordance with any one of the preceding claims, **characterized in that** the operation monitoring device (80) comprises a current measuring device (94) for detecting the electric current flowing into the laser diode (20).

9. Diode laser device in accordance with any one of the preceding claims, **characterized in that** the operation monitoring device determines a quantity (U) representing the electric voltage dropping at the laser diode (14).

10. Diode laser device in accordance with Claim 9, **characterized in that** the operation monitoring device (80) comprises a voltage measuring device (92) for detecting the electric voltage (U) dropping at the laser diode (14).

11. Diode laser device in accordance with any one of the preceding claims, **characterized in that** the operation monitoring device (80) determines an electrical quantity (G_{E}) representing the electric power supplied to the laser diode (14).

12. Diode laser device in accordance with Claim 11, **characterized in that** the operation monitoring device (80) determines the operational quantity (F) from the electrical quantity (G_{E}) and the thermal quantity (G_{T}).

13. Diode laser device in accordance with any one of the preceding claims, **characterized in that** the operational quantity (F) represents the optical output power of the laser diode (14).

14. Diode laser device in accordance with any one of the preceding claims, **characterized in that** the diode laser device comprises several laser diodes (14).

15. Diode laser device in accordance with Claim 14, **characterized in that** the several laser diodes (14) are electrically connected in series, and **in that** the operation monitoring device (80) detects the electric current flowing through all the laser diodes (14).

16. Diode laser device in accordance with Claim 14 or 15, **characterized in that** the operation monitoring device (80) detects the electric voltage (U) dropping at all the laser diodes (14) electrically connected in series.

17. Diode laser device in accordance with any one of Claims 14 to 16, **characterized in that** the coolant flows in parallel through the heat sinks (20) of the several laser diodes (14).

18. Diode laser device in accordance with any one of the preceding claims, **characterized in that** the cooling device (76) comprises a cooling circuit (78) for the coolant.

## Revendications

1. Dispositif à diodes laser comprenant au moins une diode laser (14), une alimentation en courant (54) pour la diode laser (14) et un dispositif de refroidissement (76) doté d'un refroidisseur (20) sur lequel est disposée la diode laser (14), ainsi que d'une alimentation en agent réfrigérant (66, 68, 70, 72, 74) qui permet à un agent réfrigérant de traverser le refroidisseur (20),
**caractérisé**
- **en ce qu'**il est prévu un dispositif (80) de surveillance du fonctionnement, et
- **en ce que** le dispositif (80) de surveillance du fonctionnement détecte une variable (I) représentant le courant électrique traversant la diode laser (14), et une variable (T_{R}) représentant la température de l'agent réfrigérant sortant du refroidisseur (20) et, d'après ces variables, détermine une variable de fonctionnement (F) représentant le fonctionnement du dispositif à diodes laser.

2. Dispositif à diodes laser selon la revendication 1,
**caractérisé en ce que** le dispositif (80) de surveillance du fonctionnement détecte, au moyen d'un capteur (88), la température (T_{R}) de l'agent réfrigérant sortant du refroidisseur (20).

3. Dispositif à diodes laser selon la revendication 1 ou 2,
**caractérisé en ce que** le dispositif (80) de surveillance du fonctionnement calcule une variable (ΔT) représentant la différence de température (ΔT) entre l'agent réfrigérant entrant dans le refroidisseur (20) et l'agent réfrigérant sortant du refroidisseur (20).

4. Dispositif à diodes laser selon la revendication 3,
**caractérisé en ce que** le dispositif (80) de surveillance du fonctionnement détecte, au moyen d'un capteur (86), la température (T_{z}) de l'agent réfrigérant entrant dans le refroidisseur (20).

5. Dispositif à diodes laser selon l'une quelconque des revendications précédentes, **caractérisé en ce que** le dispositif (80) de surveillance du fonctionnement détecte une variable (D) représentant le débit de l'agent réfrigérant à travers le refroidisseur (20).

6. Dispositif à diodes laser selon la revendication 5,
**caractérisé en ce que** le dispositif (80) de surveillance du fonctionnement détecte, avec un débitmètre (90), la variable (D) représentant le débit de l'agent réfrigérant à travers le refroidisseur (20).

7. Dispositif à diodes laser selon l'une quelconque des revendications précédentes, **caractérisé en ce que** le dispositif (80) de surveillance du fonctionnement détermine une variable thermique (G_{T}) représentant la puissance calorifique dissipée par la diode laser (14), à travers le dispositif de refroidissement (76).

8. Dispositif à diodes laser selon l'une quelconque des revendications précédentes, **caractérisé en ce que** le dispositif (80) de surveillance du fonctionnement comprend un dispositif (94) de mesure du courant qui détecte le courant électrique passant dans la diode laser (14).

9. Dispositif à diodes laser selon l'une quelconque des revendications précédentes, **caractérisé en ce que** le dispositif de surveillance du fonctionnement détecte une variable (U) représentant la tension électrique chutant au niveau de la diode laser (14).

10. Dispositif à diodes laser selon la revendication 9,
**caractérisé en ce que** le dispositif (80) de surveillance du fonctionnement comprend un dispositif (92) de mesure de la tension qui détecte une tension électrique (U) chutant au niveau de la diode laser (14).

11. Dispositif à diodes laser selon l'une quelconque des revendications précédentes, **caractérisé en ce que** le dispositif (80) de surveillance du fonctionnement détermine une variable électrique (G_{E}) représentant la puissance électrique fournie à la diode laser (14).

12. Dispositif à diodes laser selon la revendication 11,
**caractérisé en ce que** le dispositif (80) de surveillance du fonctionnement détermine la variable de fonctionnement (F) d'après la variable électrique (G_{E}) et la variable thermique (G_{T}) .

13. Dispositif à diodes laser selon l'une quelconque des revendications précédentes, **caractérisé en ce que** la variable de fonctionnement (F) représente la puissance de sortie optique de la diode laser (14).

14. Dispositif à diodes laser selon l'une quelconque des revendications précédentes, **caractérisé en ce que** le dispositif à diodes laser présente plusieurs diodes laser (14).

15. Dispositif à diodes laser selon la revendication 14,
**caractérisé en ce que** les diodes laser (14) formant une pluralité de diodes sont connectées électriquement en série et **en ce que** le dispositif (80) de surveillance du fonctionnement détecte le courant électrique traversant toutes les diodes laser (14).

16. Dispositif à diodes laser selon la revendication 14 ou 15, **caractérisé en ce que** le dispositif (80) de surveillance du fonctionnement détecte la tension électrique (U) chutant au niveau de toutes les diodes laser (14) connectées électriquement en série.

17. Dispositif à diodes laser selon l'une quelconque des revendications 14 à 16, **caractérisé en ce que** les refroidisseurs (20) des diodes laser (14) formant une pluralité de diodes sont traversés parallèlement par l'agent réfrigérant.

18. Dispositif à diodes laser selon l'une quelconque des revendications précédentes, **caractérisé en ce que** le dispositif de refroidissement (76) présente un circuit de refroidissement (78) pour l'agent réfrigérant.
